# EUROPEAN PATENT APPLICATION

(11) **EP 4 676 171 A1**
(43) Date of publication of application: **07.01.2026**
(21) Application number: 24777520.8
(22) Date of filing: 04.02.2024
(51) Int. Cl.: H05K 1/14

(54) **CIRCUIT BOARD AND DEVICE**

(30) Priority: 31.03.2023 CN 202310363653
(71) Applicant: HUAWEI TECHNOLOGIES CO., LTD., Shenzhen 518129 (CN)
(72) Inventor: GUO, Xiang, Shenzhen, Guangdong 518129 (CN); DING, Libin, Shenzhen, Guangdong 518129 (CN); ZHANG, Qun, Shenzhen, Guangdong 518129 (CN); ZHU, Wenxue, Shenzhen, Guangdong 518129 (CN); QU, Zhijun, Shenzhen, Guangdong 518129 (CN); WANG, Xiaodong, Shenzhen, Guangdong 518129 (CN); SUN, Changxing, Shenzhen, Guangdong 518129 (CN)
(74) Representative: Pfenning, Meinig & Partner mbB
(86) International application number: PCT/CN2024/075712
(87) International publication number: WO 2024/198726

(57) **Abstract**

This application provides a circuit board and an electronic device. In addition to a PCB, the circuit board may further include an FPC assembled on the PCB. In addition, a line between different components assembled on the PCB includes a line in the PCB, and further includes a line in the FPC. Because a quantity of core boards in the FPC is generally far less than a quantity of core boards in the PCB, selecting a core board with a dielectric loss less than that of the PCB for the FPC helps reduce a transmission loss of a high-speed signal in the circuit board, and helps reduce costs of the circuit board. This application further provides an electronic device. Selecting, for the electronic device, the circuit board provided in this application helps improve cost competitiveness of the electronic device in a high-speed high-density scenario.

## Description

This application claims priority to Chinese Patent Application No. 202310363653.5, filed with the China National Intellectual Property Administration on March 31, 2023 and entitled "CIRCUIT BOARD AND DEVICE", which is incorporated herein by reference in its entirety.

### TECHNICAL FIELD

This application relates to the field of electronic technologies, and in particular, to a circuit board and a device.

### BACKGROUND

A printed circuit board (printed circuit board, PCB) is an important part of an electronic device. The PCB includes a plurality of core boards that can provide support and electrical interconnection for components in the electronic device. Currently, a design of transmission lines in the PCB tends to develop toward high speed and high density, to improve performance of the electronic device.

However, with an increase in a quantity of transmission lines in the PCB, a quantity of core boards in the PCB is increased significantly. To reduce a loss of a high-speed signal in the PCB, the core board in the PCB needs to be made of an expensive material with a low dielectric loss. An increase in both the quantity of core boards in the PCB and costs of the core boards greatly reduces cost competitiveness of the electronic device in a high-speed high-density scenario.

### SUMMARY

This application provides a circuit board and a device, to improve cost competitiveness of an electronic device in a high-speed high-density scenario.

According to a first aspect, this application provides a circuit board, including a printed circuit board PCB and one or more flexible printed circuits FPCs assembled on the PCB. The one or more FPCs include a first FPC, and one or more transmission lines are arranged in the first FPC. One or more transmission line groups are arranged in the PCB, a first transmission line group in the one or more transmission line groups includes a first transmission line and a second transmission line, and a first end of the first transmission line and a first end of the second transmission line are electrically connected to two ends of a third transmission line in the one or more transmission lines. For example, the first end of the first transmission line is electrically connected to a first end of the third transmission line, and the first end of the second transmission line is electrically connected to a second end of the third transmission line. In addition, a second end of the first transmission line and a second end of the second transmission line are configured to electrically connect to different components. For example, the second end of the first transmission line is configured to electrically connect to a first component, the second end of the second transmission line is configured to electrically connect to a second component, and the first component and the second component are configured to be assembled on the PCB.

In this way, selecting a core board with a dielectric loss less than that of the PCB for the first FPC helps reduce a transmission loss of a high-speed signal in the circuit board, to meet a requirement in a high-speed scenario. In addition, because a quantity of core boards in the FPC is generally far less than a quantity of core boards in the PCB, compared with selecting an expensive core board with a low dielectric loss for the PCB, selecting a core board with a low dielectric loss for the first FPC helps reduce costs of the circuit board, and further improves cost competitiveness of an electronic device in a high-speed high-density scenario.

Optionally, a plurality of junction portions may be disposed on the PCB, and the junction portion is used for assembly of a component. In addition, the junction portion may include one or more pins (or referred to as pins), and the pin is electrically connected to a transmission line in the PCB. When the component is assembled on the junction portion, a corresponding transmission line in the PCB is electrically connected to the component. For example, a first junction portion is disposed on the PCB, the first junction portion is used for assembly of the first component, and the second end of the first transmission line is electrically connected to a pin of the first junction portion. After the first component is assembled on the first junction portion, the second end of the first transmission line is electrically connected to the first component through the pin. A structure of the junction portion is not limited in this application.

Optionally, a plurality of connection portions may be disposed on the PCB, and the connection portion is used for assembly of the FPC. In addition, the connection portion includes one or more pins, and the pin is electrically connected to a transmission line in the PCB. After the FPC is assembled on the connection portion, a corresponding transmission line in the PCB is electrically connected to a transmission line in the FPC. For example, a first connection portion is disposed on the PCB, the first connection portion is used for assembly of the first FPC, and the first end of the first transmission line and the first end of the second transmission line are electrically connected to different pins of the first connection portion. After the first FPC is assembled on the first connection portion, the first end of the first transmission line and the first end of the second transmission line are electrically connected to the two ends of the third transmission line respectively through corresponding pins. A structure of the connection portion is not limited in this application.

Optionally, a plurality of matching connection portions may be disposed on the FPC, and the matching connection portion is configured to connect to a connection portion on the PCB in a matching manner. In addition, the matching connection portion includes one or more pins, and the pin is electrically connected to an end of a transmission line in the FPC. After the matching connection portion is connected to the connection portion in a matching manner, a corresponding transmission line in the PCB is electrically connected to a corresponding transmission line in the FPC. For example, a first matching connection portion is disposed on the FPC, the first matching connection portion is configured to connect to the first connection portion in a matching manner, and the first end and the second end of the third transmission line are electrically connected to different pins of the first matching connection portion. After the first matching connection portion is assembled on the first connection portion, the first end of the first transmission line and the first end of the second transmission line are electrically connected to the two ends of the third transmission line respectively through corresponding pins. A structure of the matching connection portion is not limited in this application.

The PCB or one of the one or more FPCs is referred to as a target circuit board, and the one of the one or more FPCs may be any FPC or a specific FPC (for example, the first FPC). A transmission line in the target circuit board may include a differential pair and/or a single-ended line. Optionally, a target transmission line may be arranged in the target circuit board, and the target transmission line is a differential pair. The target transmission line includes a first line and a second line, and the first line includes a plurality of coupled trace sections. The coupled trace section is a trace section that is in the first line and that is coupled to the second line, and the plurality of coupled trace sections are coupled to the second line. In addition, spacings between at least two of the plurality of coupled trace sections and the second line are different. For ease of description, in this application, a spacing between a coupled trace section and the second line is referred to as a coupling spacing of the coupled trace section.

That spacings between at least two of the plurality of coupled trace sections and the second line are different may mean that spacings between any two of the at least two coupled trace sections and the second line are different, or values of coupling spacings of the plurality of coupled trace sections include a plurality of values. In this application, two values in the plurality of values are referred to as a first value and a second value, and it is assumed that the first value is less than the second value.

Optionally, the coupled trace section may be a conductive line arranged in a conductive layer in a core board, and may not include a conductive line in a through via. A single coupled trace section may be located in a same conductive layer.

In this application, a coupled trace section that is in the plurality of coupled trace sections and that is closest to the first end of the first line is referred to as a first outlet trace section. Optionally, a coupling spacing of the first outlet trace section is the first value.

In this application, a coupled trace section that is in the plurality of coupled trace sections and that is closest to the second end of the first line is referred to as a second outlet trace section. Optionally, a coupling spacing of the second outlet trace section is the first value or the second value.

A coupling spacing of at least one coupled trace section (referred to as a non-outlet trace section) other than the first outlet trace section and the second outlet trace section in the plurality of coupled trace sections may be a second spacing or greater than the second spacing.

The target circuit board may be the PCB, and the target transmission line may be any transmission line in the PCB, the first transmission line, or the second transmission line. A coupling spacing of an outlet trace section affects a spacing between pins connected to lines. Setting a value of a coupling spacing of an outlet trace section to a small value (for example, the first value) helps reduce a spacing between a pin connected to the first line and a pin connected to the second line, to meet a requirement of a small-sized highly-integrated circuit. Setting a value of a coupling spacing of a non-outlet trace section to a large value (for example, the second value) helps reduce a crosstalk loss of a differential signal transmitted in the target transmission line.

The target circuit board may be the FPC, and the target transmission line may be any transmission line in the FPC or the third transmission line. A coupling spacing of an outlet trace section affects a spacing between pins connected to lines. Setting a value of a coupling spacing of an outlet trace section to a small value (for example, the first value) helps reduce a spacing between a pin connected to the first line and a pin connected to the second line, to reduce a spacing between pins of the PCB that are connected to pins of the FPC in a matching manner, and meet a requirement for miniaturization and high integration of the PCB. Setting a coupling spacing of a non-outlet trace section to a large value (for example, the second value) helps reduce a crosstalk loss of a differential signal transmitted in the target transmission line.

In conclusion, a coupled trace section with a small coupling spacing (for example, the coupling spacing is the first value) is disposed at an end part of the first line or at a position close to the end part. This helps increase pin density of the target circuit board, to meet a requirement in a high-density scenario. In addition, a coupled trace section with a large coupling spacing (for example, the coupling spacing is the second value) is disposed at a middle part between two ends of the first line. This helps reduce a crosstalk loss of a differential signal in the target transmission line, to meet a requirement in a high-speed scenario.

Coupling of two lines may mean that the two lines are close to each other, so that edge electric fields and magnetic fields of the two lines cover each other during transmission of signals in the two lines.

Optionally, a spacing between the coupled trace section and the second line may be a spacing between projections of the coupled trace section and a trace section that is in the second line and that is coupled to the coupled trace section onto a surface of the PCB.

Optionally, a first coupled trace section in the at least two coupled trace sections and the second line are broadside-coupled to each other in the target circuit board.

Optionally, the at least two coupled trace sections include a second coupled trace section, and the second coupled trace section and the second line are broadside-coupled to each other in the target circuit board.

That two lines are broadside-coupled to each other in the target circuit board may mean that the two lines are located at different thicknesses of the target circuit board or in different conductive layers. In this application, a spacing between projections of the first coupled trace section and a trace section (referred to as a first trace section) that is in the second line and that is coupled to the first coupled trace section onto a surface of the target circuit board is referred to as a first spacing, and a spacing between projections of the second coupled trace section and a trace section (referred to as a second trace section) that is in the second line and that is coupled to the second coupled trace section onto the surface of the target circuit board is referred to as a second spacing. A routing manner of broadside coupling helps reduce the first spacing and the second spacing.

The first spacing is different from the second spacing. It is assumed that a value of the first spacing is the first value, and a value of the second spacing is the second value. The first coupled trace section is disposed at the end part of the first line, or the first coupled trace section is an outlet trace section. This helps further increase pin density of the target circuit board. The second coupled trace section is disposed at the middle part of the first line, or the second coupled trace section is a non-outlet trace section. This helps reduce a size of the target circuit board.

Optionally, the at least two coupled trace sections include a third coupled trace section, and the third coupled trace section and the second line are edge-coupled to each other in the target circuit board.

That two lines are edge-coupled to each other in the target circuit board may mean that the two lines are located at a same thickness of the target circuit board or in a same conductive layer. In this application, a spacing between projections of the third coupled trace section and a trace section (referred to as a third trace section) that is in the second line and that is coupled to the third coupled trace section onto the surface of the target circuit board is referred to as a third spacing. The first spacing is different from the third spacing, and the second spacing is different from the third spacing. The third coupled trace section and the third trace section are disposed at a same thickness of the target circuit board, so that the third coupled trace section and the third trace section are connected to pins of the target circuit board separately through vias of a same length, to reduce a delay difference of a differential signal, and reduce a transmission loss of the differential signal in a differential pair.

Optionally, the plurality of coupled trace sections include a fourth coupled trace section adjacent to the first coupled trace section, the first line further includes a first intermediate trace section located between the first coupled trace section and the fourth coupled trace section, and there is at least one position of intersection between projections of the first intermediate trace section and the second line onto the surface of the target circuit board. Cross-interchanging transmission positions of a positive signal and a negative signal in a differential signal helps reduce crosstalk between the positive signal and the negative signal, to meet a requirement in a high-speed scenario. A quantity of positions of intersection is not limited in this application.

Optionally, the target circuit board includes a plurality of core boards, a bonding layer is disposed between two adjacent core boards in the plurality of core boards, and the first coupled trace section and the trace section (referred to as the first trace section) that is in the second line and that is coupled to the first coupled trace section are prefabricated on different surfaces of a same core board (referred to as a first core board) in the plurality of core boards. Because precision of a process for prefabricating a line on a core board is far higher than precision of an alignment and lamination process, this helps reduce a layer deviation of the first coupled trace section and the first trace section, to reduce impedance fluctuation and crosstalk fluctuation of a differential pair and improve signal integrity (signal integrity, SI) of the differential pair.

A core board generally includes an insulating layer and a conductive layer disposed on a surface of the insulating layer. In this case, the first coupled trace section and the first trace section may be prefabricated in different conductive layers in the first core board.

Optionally, the first core board includes an insulating layer, and a material of the insulating layer includes an organic flexible material or an inorganic flexible material; the organic flexible material includes at least one of the following: polyimide PI, polytetrafluoroethylene PTFE, liquid crystal polymer LCP, modified polyimide MPI, polyester film, perfluoropropyl perfluorovinyl ether, and polyfluoroalkoxy FPA; and the inorganic flexible material includes carbon fiber or glass fiber cloth.

Optionally, an end of the first line starts from the first coupled trace section, and is connected to a first via in the target circuit board through a first access trace section. The first via is a pin of the target circuit board, or the first via is connected to a pin of the target circuit board. An end of the second line starts from the first trace section, and is connected to a second via in the target circuit board through a second access trace section. The second via is a pin of the target circuit board, or the second via is connected to a pin of the target circuit board.

Optionally, for any position on the first coupled trace, a distance between the position and the first via is the same as a distance between the position and the second via. This helps avoid electric leakage caused by an excessively small distance between the first line and the first via or the second via.

Optionally, a length of the first via is less than a length of the second via, and a length of the first access trace section may be greater than a length of the second access trace section, to compensate for a difference between the lengths of the first via and the second via, and reduce a delay difference of a differential signal.

In this application, an example in which the circuit board includes a PCB and one or more FPCs is used. The PCB or at least one FPC may be replaced with a circuit board of another material, provided that the circuit board can provide electrical interconnection.

According to a second aspect, this application provides a circuit board, including a printed circuit board PCB and one or more connection portions on the PCB. A first connection portion in the one or more connection portions is used for assembly of a first flexible printed circuit FPC in one or more FPCs, and one or more transmission lines are arranged in the first FPC. One or more transmission line groups are disposed in the PCB, a first transmission line group in the one or more transmission line groups includes a first transmission line and a second transmission line, and a second end of the first transmission line and a second end of the second transmission line are configured to electrically connect to different components. In addition, when the first FPC is assembled on at least one of the one or more connection portions, a first end of the first transmission line and a first end of the second transmission line are electrically connected to two ends of a third transmission line in the first FPC respectively.

Optionally, the first connection portion includes a first connection structure, the first connection structure includes at least one pad or at least one via formed on the PCB, and the first end of the first transmission line is electrically connected to one pad in the at least one pad or one via in the at least one via. This helps reduce a length of a differential pair and reduce a transmission loss of a differential signal in the circuit board.

Optionally, the first connection portion includes a second connection structure, the second connection structure is a connector assembled on the PCB, and the first end of the second transmission line is electrically connected to a pin of the connector.

Optionally, for understanding of features and beneficial effects of the circuit board provided in the second aspect, refer to related features and beneficial effects of the PCB in the circuit board provided in the first aspect or any optional manner of the first aspect.

According to a third aspect, this application provides a circuit board. One or more transmission lines are arranged in the circuit board, the one or more transmission lines include a target transmission line, the target transmission line is a differential pair, the differential pair includes a first line and a second line, the first line includes a plurality of coupled trace sections, the plurality of coupled trace sections are coupled to the second line, and spacings between at least two of the plurality of coupled trace sections and the second line are different.

Optionally, a first coupled trace section in the at least two coupled trace sections and the second line are broadside-coupled to each other in the circuit board.

Optionally, the at least two coupled trace sections include a second coupled trace section, and the second coupled trace section and the second line are broadside-coupled to each other in the circuit board.

Optionally, the at least two coupled trace sections include a third coupled trace section, and the third coupled trace section and the second line are edge-coupled to each other in the circuit board.

Optionally, a spacing between the first coupled trace section and the second line is a spacing between projections of the first coupled trace section and a trace section that is in the second line and that is coupled to the first coupled trace section onto a surface of the circuit board.

Optionally, the plurality of coupled trace sections include a fourth coupled trace section adjacent to the first coupled trace section, the first line further includes a first intermediate trace section located between the first coupled trace section and the fourth coupled trace section, and there is at least one position of intersection between projections of the first intermediate trace section and the second line onto the surface of the circuit board.

Optionally, the circuit board includes a plurality of core boards, a bonding layer is disposed between two adjacent core boards in the plurality of core boards, and the first coupled trace section and the trace section that is in the second line and that is coupled to the first coupled trace section are prefabricated on different surfaces of a first core board in the plurality of core boards.

Optionally, an end of the first line starts from the first coupled trace section, and is connected to a first via in the circuit board through a first access trace section. The first via is a pin of the circuit board, or the first via is connected to a pin of the circuit board. An end of the second line starts from a first trace section, and is connected to a second via in the circuit board through a second access trace section. The second via is a pin of the circuit board, or the second via is connected to a pin of the circuit board.

Optionally, for any position on the first coupled trace, a distance between the position and the first via is the same as a distance between the position and the second via. This helps avoid electric leakage caused by an excessively small distance between the first line and the first via or the second via.

Optionally, a length of the first via is less than a length of the second via, and a length of the first access trace section may be greater than a length of the second access trace section, to compensate for a difference between the lengths of the first via and the second via, and reduce a delay difference of a differential signal.

The circuit board provided in the third aspect may be a printed circuit board PCB or a flexible printed circuit FPC.

Optionally, for understanding of features and beneficial effects of the circuit board provided in the third aspect, refer to related features and beneficial effects of the first FPC in the circuit board provided in the first aspect or any optional manner of the first aspect.

According to a fourth aspect, this application provides an electronic device, including one or more circuit boards and a plurality of components assembled on the one or more circuit boards. At least one of the one or more circuit boards is the circuit board according to the first aspect or any optional manner of the first aspect, the second aspect or any optional manner of the second aspect, or the third aspect or any optional manner of the third aspect.

Optionally, the electronic device further includes a housing, and the one or more circuit boards are disposed in the housing.

For understanding of features and beneficial effects of the circuit board in the electronic device provided in the fourth aspect, refer to related features and beneficial effects of any circuit board provided above.

### BRIEF DESCRIPTION OF DRAWINGS

FIG. 1-1 and FIG. 1-2 are a schematic top view and a schematic sectional view of a circuit respectively;
FIG. 2-1 and FIG. 2-2 are a schematic top view and a schematic sectional view of another circuit respectively;

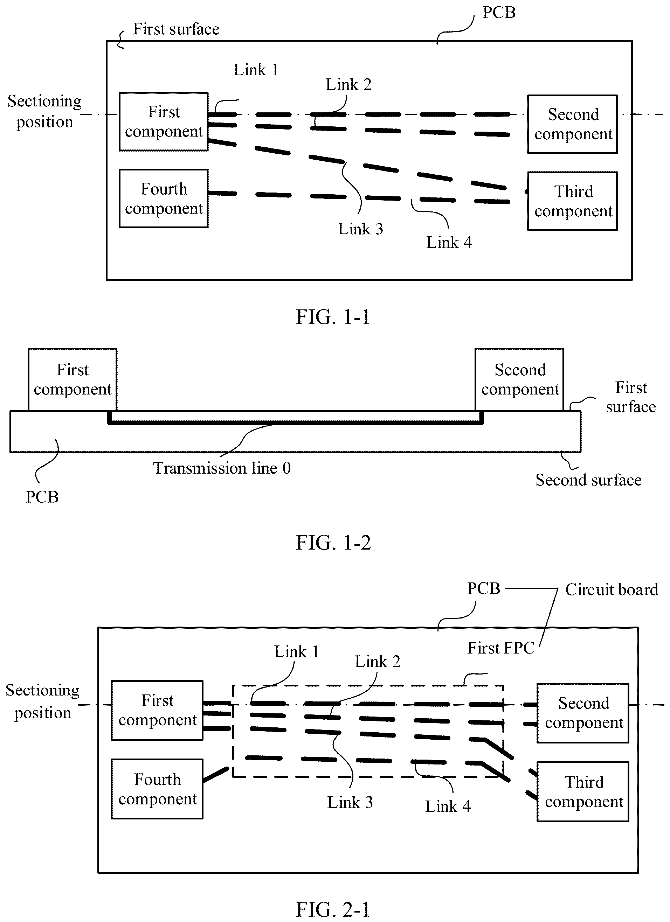

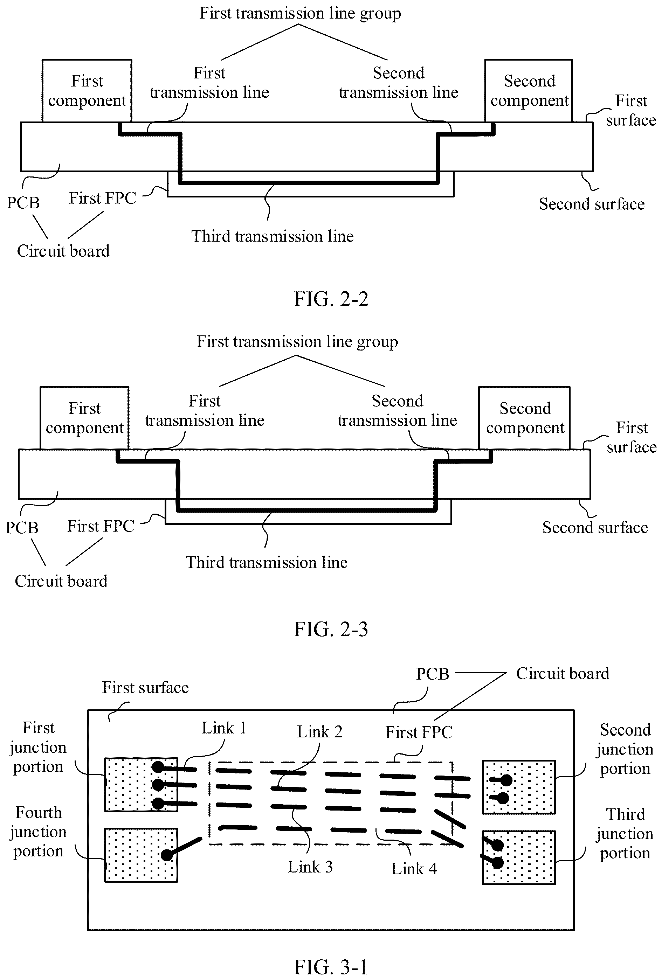

FIG. 2-3 is a schematic top view of another circuit;

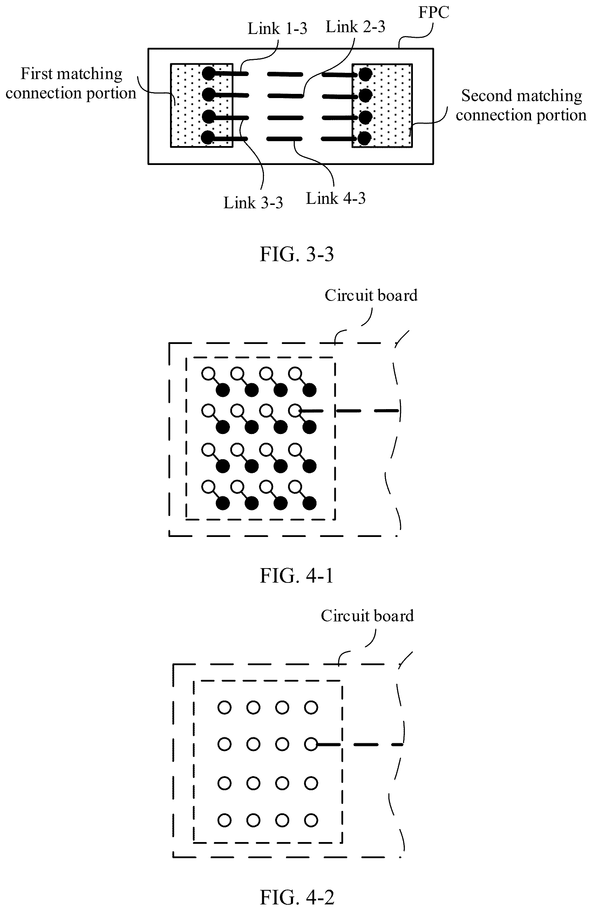

FIG. 3-1 to FIG. 3-3 schematically show possible structures of a circuit board;

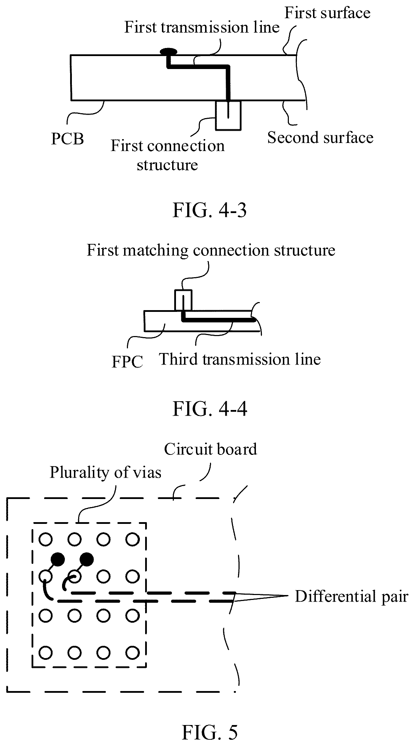

FIG. 4-1 to FIG. 4-4 schematically show possible partial structures of a circuit board;
FIG. 5 is a possible schematic partial top view of a circuit board on which a differential pair is arranged;

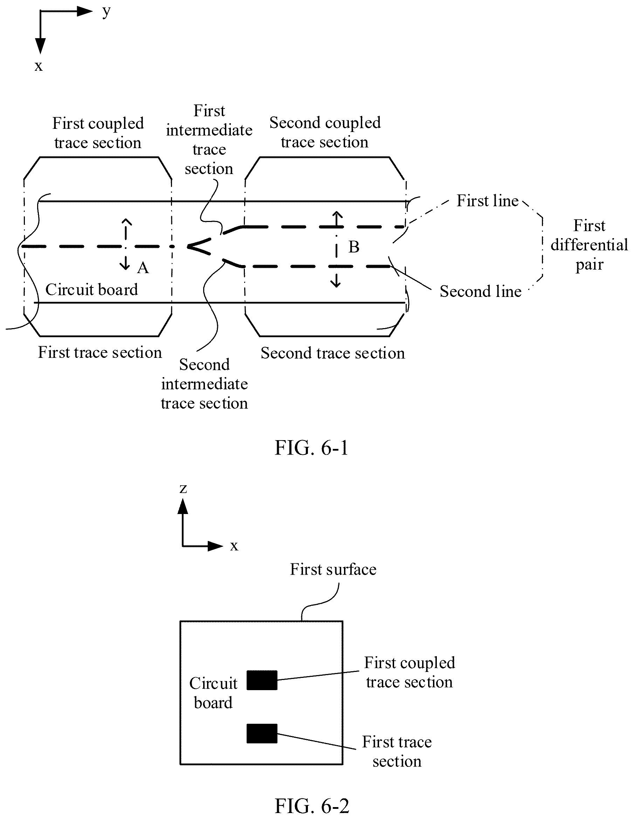

FIG. 6-1 is a possible schematic partial top view of a circuit board on which a differential pair is arranged;

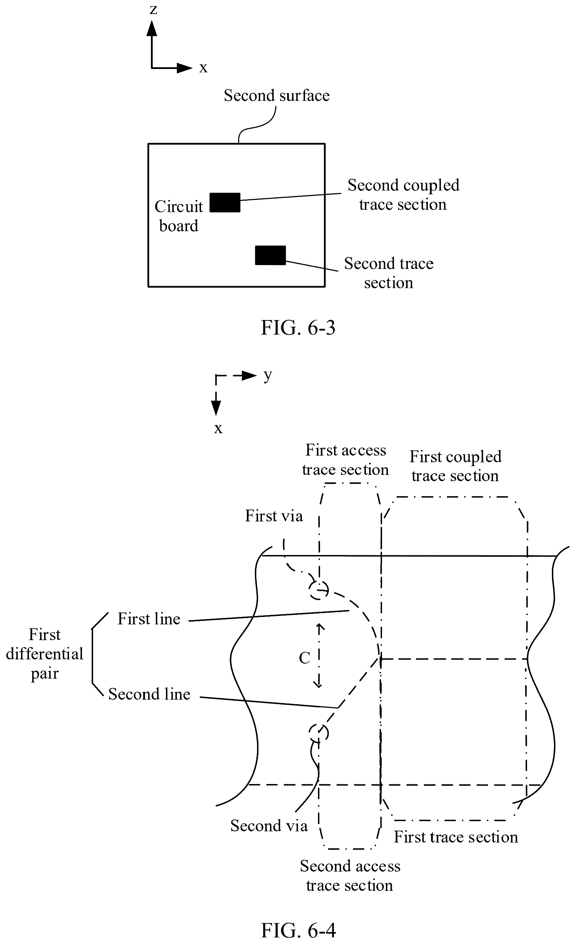

FIG. 6-2 and FIG. 6-3 are schematic sectional views of the circuit board shown in FIG. 6-1;

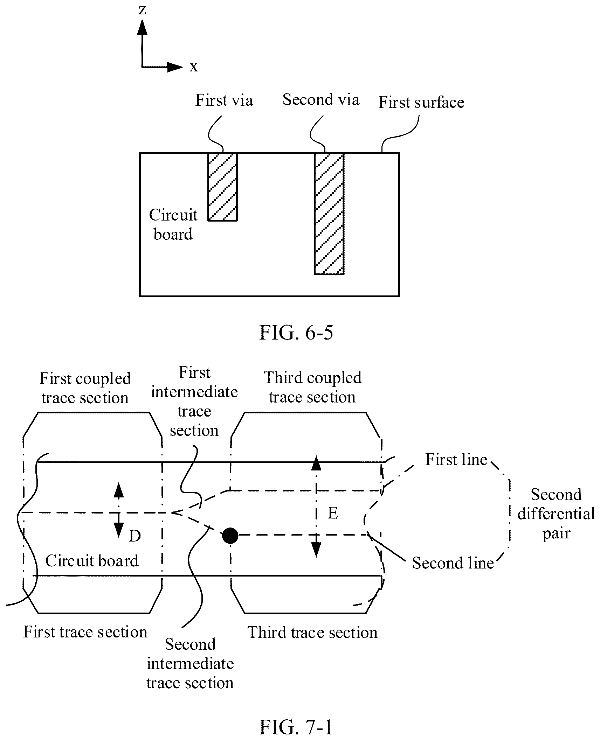

FIG. 6-4 and FIG. 6-5 are a possible schematic partial top view and a possible schematic sectional view of a circuit board on which a differential pair is arranged respectively;

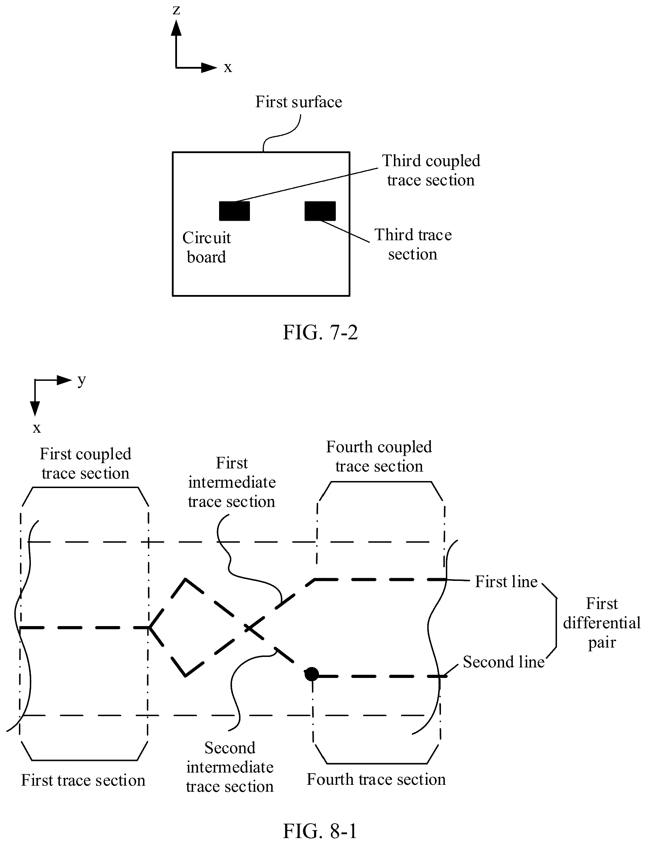

FIG. 7-1 and FIG. 7-2 are a possible schematic partial top view and a possible schematic sectional view of a circuit board on which a differential pair is arranged respectively;

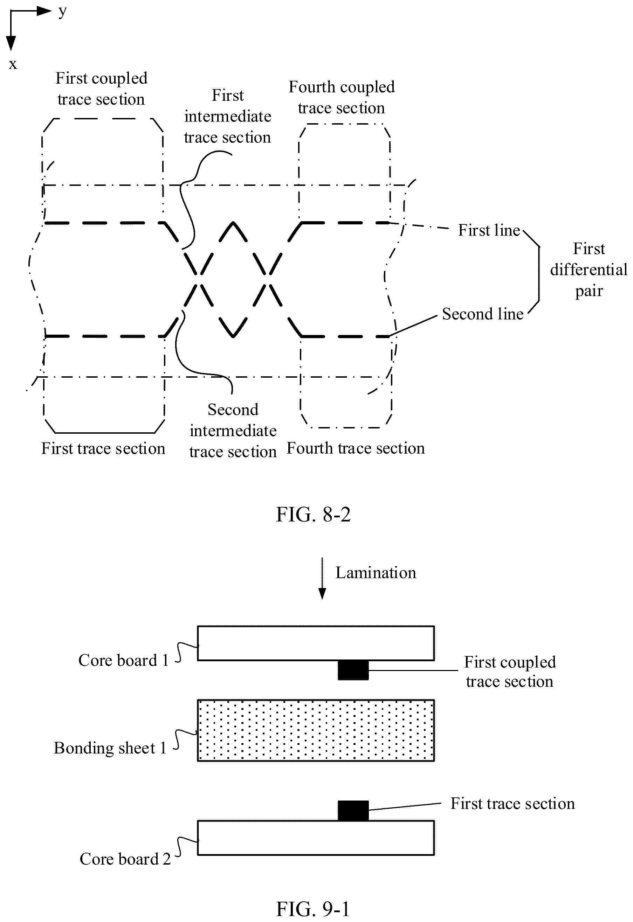

FIG. 8-1 and FIG. 8-2 are possible schematic partial top views of a circuit board on which a differential pair is arranged;
FIG. 9-1 schematically shows a possible processing process of a circuit board;

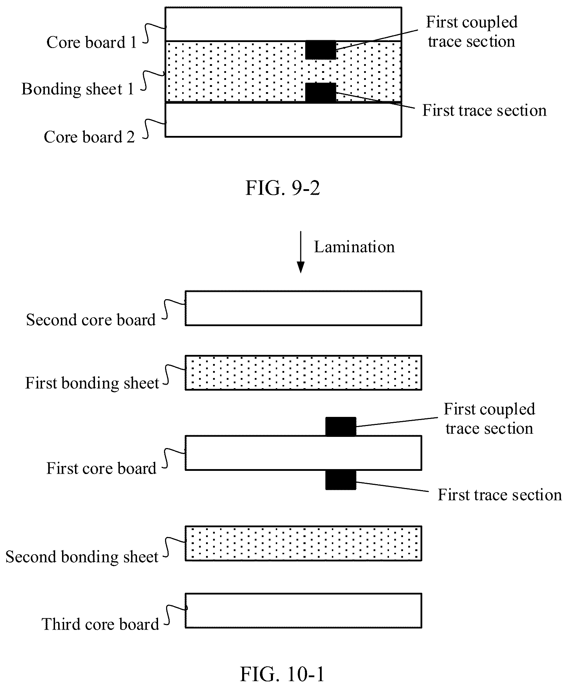

FIG. 9-2 schematically shows a circuit board prepared according to the processing process shown in FIG. 9-1;
FIG. 10-1 schematically shows another possible processing process of a circuit board;

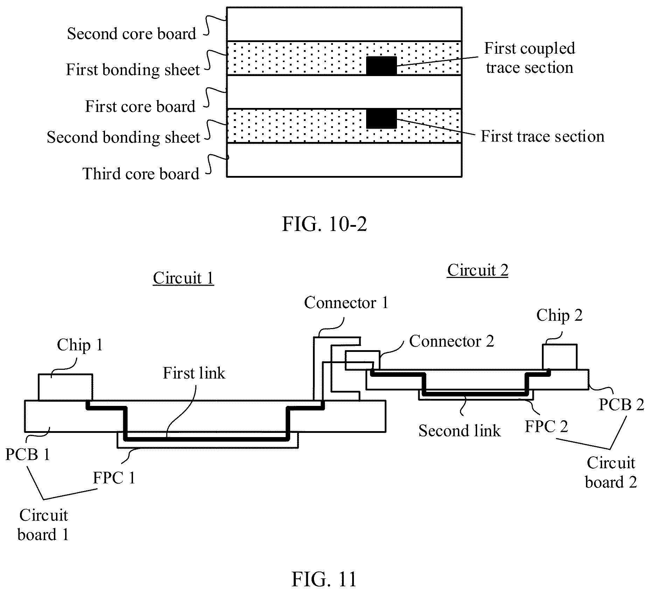

FIG. 10-2 schematically shows a circuit board prepared according to the processing process shown in FIG. 10-1; and
FIG. 11 schematically shows a possible structure of an electronic device.

### DESCRIPTION OF EMBODIMENTS

This application provides an electronic device. The electronic device may be a circuit. The circuit may include but is not limited to a circuit board and a plurality of electronic components (briefly referred to as components) assembled on the circuit board, and the circuit board may further provide conductive links (briefly referred to as links) for different components.

In a first possible design, the circuit board is a printed circuit board (printed circuit board, PCB). The PCB is an important part of the electronic device. The PCB is generally formed by laminating a plurality of core boards with prefabricated lines. The core board includes an insulating layer and a conductive layer (for example, copper foil). A quantity of conductive layers in the core board is not limited in this application. For example, a conductive layer is disposed on one surface of the insulating layer and no conductive layer is disposed on another surface, or a conductive layer is disposed on both surfaces of the insulating layer. A transmission line in the PCB may include a conductive line (briefly referred to as a line) prefabricated in the conductive layer, and the line in the conductive layer is configured to implement electrical interconnection between different positions in the same conductive layer. Generally, a metallized via (briefly referred to as a via) is further provided between different conductive layers, to implement electrical interconnection between the different conductive layers.

The circuit board may provide links for different components by using transmission lines arranged in the PCB. The transmission line in the PCB may include lines in one or more conductive layers and one or more vias.

Based on the first possible design of the circuit board, the following describes a possible structure of the circuit with reference to FIG. 1-1 and FIG. 1-2.

FIG. 1-1 is a top view of the circuit. Refer to FIG. 1-1. The circuit includes a PCB and a first component to a fourth component that are assembled on the PCB. In FIG. 1-1, dashed lines represent links between different components. Refer to FIG. 1-1. The first component and the second component are electrically connected through a link 1 and a link 2, the first component and the third component are electrically connected through a link 3, and the fourth component and the third component are electrically connected through a link 4.

In the first possible design, because the circuit board is a PCB, the link 1 to the link 4 are transmission lines in the PCB. FIG. 1-2 is a sectional view of the PCB in a plane in which the link 1 is located. Refer to FIG. 1-2. The link 1 is a transmission line 0 in the PCB, a trace section that is in the transmission line 0 and that is parallel to a surface of the PCB may be a line in a conductive layer in the PCB, and a trace section that is in the transmission line 0 and that is perpendicular to the surface of the PCB may be a via in the PCB.

To meet a requirement for application of the electronic device in a high-speed scenario, a manufacturer needs to select a core board with a low dielectric loss to manufacture a PCB, to reduce a loss generated when a high-speed signal is transmitted in a transmission line in the PCB. To meet a requirement for application of the electronic device in a high-density scenario, the manufacturer needs to continuously increase a quantity of core boards in the PCB, to provide electrical interconnection for more components on the PCB. The core board with the low dielectric loss is generally expensive, and an increase in both costs of the core boards and the quantity of core boards greatly reduces cost competitiveness of the electronic device in a high-speed high-density scenario.

To improve competitiveness of the electronic device in a high-speed high-density scenario, this application provides another possible design (referred to as a second possible design) of the circuit board. In comparison with the first possible design, in the second possible design, in addition to a PCB, the circuit board further includes at least one flexible printed circuit (flexible printed circuit, FPC) assembled on the PCB, and at least one link in the circuit board is a hybrid link. A single hybrid link includes a transmission line in the PCB, and further includes a transmission line in the FPC. In this application, the second possible design of the circuit board is also referred to as a hybrid-link circuit board.

In other words, the FPC is equivalent to an extended circuit board of the PCB. For one or more links (for example, high-speed links) originally implemented by using a transmission line in the PCB, a part of trace section in the transmission line is moved to the FPC. This helps reduce density of transmission lines in the PCB, and helps further increase a quantity of components assembled on the PCB, to meet a requirement in a high-density scenario. In addition, transmission lines in the FPC are generally less than those in the PCB. Therefore, a quantity of core boards in the FPC is smaller, and the FPC may be manufactured by using a core board with a low loss, to reduce a loss of a signal transmitted in the FPC while maintaining cost competitiveness, to meet a requirement in a high-speed scenario.

The following continues to describe the circuit based on the hybrid-link circuit board.

FIG. 2-1 is a schematic top view of the circuit. Refer to FIG. 2-1. The circuit includes a circuit board and a plurality of components assembled on the circuit board, and the circuit board includes a PCB and a first FPC assembled on the PCB. One or more transmission lines may be arranged in the PCB, and one or more transmission lines may be arranged in the first FPC.

In FIG. 2-1, an example in which the plurality of components include a first component to a fourth component is used. Optionally, the plurality of components may include more or fewer components. In FIG. 2-1, an example in which the plurality of components are assembled on a same surface of the PCB is used. Optionally, the plurality of components may be assembled on different surfaces of the PCB. A manner for assembling the components on the PCB is not limited in this application. The following describes several possible assembly manners by using examples. Details are not described herein.

The PCB and the first FPC may jointly provide a link for electrical interconnection between different components. In FIG. 2-1, bold dashed lines represent links in the circuit board. Same as the circuit board shown in FIG. 1-1, in the circuit board shown in FIG. 2-1, the first component and the second component are electrically connected through a link 1 and a link 2, the first component and the third component are electrically connected through a link 3, and the fourth component and the third component are electrically connected through a link 4. A difference from the circuit board shown in FIG. 1-1 lies in that each of the link 1 to the link 4 shown in FIG. 2-1 is a hybrid link, and a single hybrid link includes two transmission lines in the PCB (for example, a transmission line on a left side and a transmission line on a right side of a dashed box in FIG. 2-1) and a transmission line in the FPC (for example, a transmission line in the dashed box in FIG. 2-1).

For ease of description, the two transmission lines that are in the PCB and that are in the single hybrid link are referred to as two transmission lines in a same transmission line group. FIG. 2-2 is a schematic sectional view of the circuit board in a plane in which the link 1 is located. Refer to FIG. 2-2. The link 1 in the circuit board may include a first transmission line in the PCB, a third transmission line in the first FPC, and a second transmission line in the PCB. The first transmission line and the second transmission line are two transmission lines in a first transmission line group. Two ends of the first transmission line are electrically connected to the third transmission line and the first component respectively. In this application, an end that is of the first transmission line and that is electrically connected to the third transmission line is referred to as a first end of the first transmission line, and an end that is of the first transmission line and that is electrically connected to the first component is referred to as a second end of the first transmission line. Two ends of the second transmission line are electrically connected to the third transmission line and the second component respectively. In this application, an end that is of the second transmission line and that is electrically connected to the third transmission line is referred to as a first end of the second transmission line, and an end that is of the second transmission line and that is electrically connected to the second component is referred to as a second end of the second transmission line.

Similar to the PCB, the FPC is generally formed by laminating one or more core boards with prefabricated lines by using a bonding sheet. A transmission line in the FPC may include a prefabricated line (for example, a line segment parallel to a surface of the FPC in FIG. 2-2) in a conductive layer of the core board and a via (for example, a line segment perpendicular to the surface of the FPC in FIG. 2-2) configured to implement interconnection between different core boards. However, a core board in the PCB is generally a rigid copper clad laminate (copper clad laminate, CCL), while a core board in the FPC is generally a flexible copper clad laminate (flexible copper clad laminate, FCCL). An insulating layer in the CCL is generally made of a non-bendable material (for example, thermosetting resin), while an insulating layer in the FPC is generally made of a material with specific bendability, for example, an organic flexible material or an inorganic flexible material. The organic flexible material includes at least one of the following: polyimide (polyimide, PI), polytetrafluoroethylene (poly tetra fluoroethylene, PTFE), liquid crystal polymer (liquid crystal polymer, LCP), modified polyimide MPI (modified polyimide, PI), polyester film, perfluoropropyl perfluorovinyl ether, and polyfluoroalkoxy (polyfluoroalkoxy, FPA). The inorganic flexible material includes carbon fiber or glass fiber cloth. A quantity of core boards in the FPC is generally less than a quantity of core boards in the PCB, and a dielectric loss of the core board in the FPC may be less than a dielectric loss of the core board in the PCB.

Based on the hybrid-link circuit board described above, a core board with a dielectric loss less than that of the PCB is selected for the first FPC, and a high-speed signal is transmitted in a hybrid link. This helps reduce a transmission loss of the high-speed signal in the circuit board, to meet a requirement in a high-speed scenario. In addition, because the quantity of core boards in the FPC is generally far less than the quantity of core boards in the PCB, compared with selecting an expensive core board with a low dielectric loss for the PCB, selecting a core board with a low dielectric loss for the first FPC helps reduce costs of the circuit board, and further improves cost competitiveness of the electronic device in a high-speed high-density scenario.

In FIG. 2-1, an example in which the circuit board includes four hybrid links is used. Optionally, the circuit board may include more or fewer hybrid links. In FIG. 2-1, an example in which each link in the circuit board is a hybrid link is used. Optionally, some links in the circuit board are hybrid links, and another link may be implemented in another manner. For example, the another link is independently implemented by using a transmission line (for example, the transmission line 0 shown in FIG. 1-2) in the PCB.

In FIG. 2-1, an example in which the first FPC includes four transmission lines is used. The first FPC may include more or fewer transmission lines. The links shown in FIG. 2-1 are merely used as an example, and connection relationships between the plurality of components are not limited in this application.

In FIG. 2-1 and FIG. 2-2, an example in which the first FPC and the component are disposed on different surfaces of the PCB is used. Optionally, the first FPC and the component may be assembled on a same surface of the PCB. A manner for assembling the first FPC on the PCB is not limited in this application. The following describes several possible assembly manners by using examples. Details are not described herein.

In FIG. 2-1, an example in which one FPC is assembled on the PCB is used. Optionally, more FPCs may be assembled on the PCB. FIG. 2-3 is a top view of another possible structure of the circuit. Refer to FIG. 2-3. A first FPC and a second FPC may be assembled on a second surface of a PCB. The first FPC and the PCB jointly provide two hybrid links (namely, a link 1 and a link 2) for a first component and a second component. The second FPC and the PCB jointly provide two hybrid links. In other words, the second FPC and the PCB jointly provide a link 3 for the first component and a third component, and jointly provide a link 4 for a fourth component and the third component.

In FIG. 2-3, an example in which different FPCs are assembled on a same surface (namely, the second surface) of the PCB is used. Optionally, the different FPCs may be assembled on different surfaces of the PCB.

In FIG. 2-1 and FIG. 2-3, an example in which all transmission lines in the FPC are transmission lines in hybrid links is used. Optionally, at least one transmission line in the FPC is not located in the hybrid links. For example, one end or two ends of the transmission line are electrically connected to a component on the PCB, instead of being connected to the component through a transmission line in the PCB. The component does not include a connector configured to connect the FPC to the PCB. However, in this case, the component needs to be assembled on the PCB, and the component needs to be electrically connected to the FPC. This increases a packaging process and packaging difficulty, and increases production costs of the component because a structure of the component needs to be modified.

This application further provides a circuit board. FIG. 3-1 is a schematic top view of the circuit board. The circuit board may be a structure of a hybrid-link circuit board before assembly of components. Therefore, the circuit board may be understood with reference to the hybrid-link circuit board described above (for example, any circuit board shown in FIG. 2-1 to FIG. 2-3). For example, with reference to FIG. 3-1, the circuit board includes a PCB and one or more FPCs. One or more transmission lines are arranged in a first FPC, one or more transmission line groups are arranged in the PCB, and two transmission lines in a transmission line group are connected to two ends of a transmission line in one FPC respectively. For example, a first transmission line group includes a first transmission line and a second transmission line, and a first end of the first transmission line and a first end of the second transmission line are electrically connected to two ends of a third transmission line in the one or more transmission lines. A difference from the foregoing hybrid-link circuit board after assembly of components lies in that the two transmission lines in the transmission line group are not yet connected to components, but are configured to connect to different components. For example, a second end of the first transmission line and a second end of the second transmission line are configured to electrically connect to a first component and a second component respectively.

A manner for connecting a transmission line in the PCB to a component is not limited in this application. Optionally, one or more junction portions are disposed on the PCB, and the junction portion is used for assembly of a corresponding component. FIG. 3-1 schematically shows a first junction portion to a fourth junction portion. The first junction portion to the fourth junction portion are used for assembly of a first component to a fourth component respectively. Optionally, more or fewer junction portions may be disposed on the PCB.

The junction portion may include one or more pins. An end of the pin is electrically connected to a transmission line in the PCB. After the corresponding component is assembled on the junction portion, another end of the pin is electrically connected to the component. For example, with reference to FIG. 3-1, in FIG. 3-1, a solid circle represents the pin of the junction portion. The first junction portion includes but is not limited to three pins, and the three pins are electrically connected to an end of a link 1, an end of a link 2, and an end of a link 3 respectively. The fourth junction portion includes but is not limited to one pin, and the pin is electrically connected to an end of a link 4. The second junction portion includes but is not limited to two pins, and the two pins are electrically connected to another end of the link 1 and another end of the link 2 respectively. The third junction portion includes but is not limited to two pins, and the two pins are electrically connected to another end of the link 3 and another end of the link 4 respectively.

A matching junction portion corresponding to the junction portion may be disposed on the component. For example, a first matching junction portion corresponding to the first junction portion is disposed on the first component. Implementations of the junction portion and the matching junction portion are not limited in this application. The following uses the first junction portion and the first matching junction portion as an example to describe possible implementations of the junction portion and the matching junction portion.

In a possible implementation, the first junction portion is a part of the PCB.

For example, the first junction portion may include at least one pad formed on the PCB, and the pad is a pin of the first junction portion. Refer to FIG. 4-1. In FIG. 4-1, a solid circle in a dashed box may represent the pad in the first junction portion, and a hollow circle in the dashed box may represent a via in the PCB. The pad is connected to a prefabricated line in a core board in the PCB through the via. The first matching junction portion may include a pad that is formed on the first component and that matches the at least one pad. After the first junction portion is soldered to the first matching junction portion, the first junction portion is fastened to the first matching junction portion, and the component can be electrically connected to a transmission line in the PCB.

For example, the first junction portion may include at least one via formed on the PCB, and the via is a pin of the first junction portion. Refer to FIG. 4-2. In FIG. 4-2, a hollow circle in a dashed box may represent a via in the PCB. The first matching junction portion may include one or more signal pins that are disposed on the first component and that match the via. The signal pin is pressed into the matching via, so that the first junction portion can be fastened to the first matching junction portion, and the signal pin can be electrically connected to a prefabricated line in a core board in the PCB.

In another possible implementation, the first junction portion is a structure assembled on the PCB.

For example, the first junction portion is a connector assembled on the PCB, the second junction portion is a connector assembled on the component, and the two connectors match each other. For example, the two connectors are a male connector (for example, a plug) and a female connector (for example, a socket or an insertion slot). The two connectors are in insertion connection to each other, and signal pins of the two connectors are in contact with and connected to each other, so that the component is electrically connected to a line in the PCB.

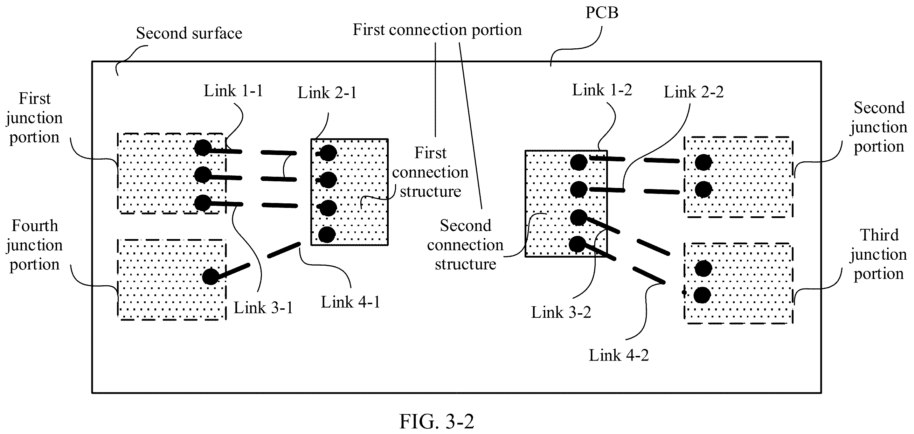

This application further provides a circuit board. FIG. 3-2 is a schematic bottom view (namely, a view in which a second surface faces upward) of the circuit board. The circuit board may be a PCB in a hybrid-link circuit board. Therefore, the circuit board may be understood with reference to the PCB shown in FIG. 3-1. For example, one or more transmission line groups are arranged in the PCB, the one or more transmission line groups include a first transmission line group, the first transmission line group includes a first transmission line and a second transmission line, a second end of the first transmission line is configured to electrically connect to a first component, and a second end of the second transmission line is configured to electrically connect to a second component. Optionally, one or more junction portions used for assembly of components are disposed on the PCB, and a transmission line in the PCB is electrically connected to the junction portion. A difference from the PCB shown in FIG. 3-1 lies in that, in the circuit board shown in FIG. 3-2, two transmission lines in a transmission line group are configured to connect to a transmission line in an FPC. For example, a first end of the first transmission line and a first end of the second transmission line are configured to electrically connect to two ends of a third transmission line in a first FPC respectively.

A manner for connecting a transmission line in the PCB to a transmission line in an FPC is not limited in this application. Optionally, one or more connection portions may be disposed on the PCB, the one or more connection portions are used for assembly of one or more FPCs, the one or more FPCs include the first FPC, and a first connection portion in the one or more connection portions is used for assembly of the first FPC. FIG. 3-2 schematically shows the first connection portion on the PCB. Refer to FIG. 3-2. The first connection portion includes a first connection structure and a second connection structure. When the first FPC is assembled on the first connection structure and the second connection structure, the first end of the first transmission line and the first end of the second transmission line are electrically connected to the two ends of the third transmission line in the first FPC respectively. Optionally, the first FPC may be assembled on the PCB by using more or fewer connection structures on the PCB.

The connection portion may include one or more pins. An end of the pin is electrically connected to a transmission line in the PCB. After a corresponding FPC is assembled on the connection portion, another end of the pin is electrically connected to a transmission line in the FPC. In FIG. 3-2, a solid circle represents a pin, and a link i-1 and a link i-2 represent two transmission lines that are of a link i and that are in a transmission line group in the PCB. Refer to FIG. 3-2. The first connection structure includes but is not limited to four pins, and the four pins are electrically connected to an end of a link 1-1, an end of a link 2-1, an end of a link 3-1, and an end of a link 4-1 respectively. The second connection structure includes but is not limited to four pins, and the four pins are electrically connected to an end of a link 1-2, an end of a link 2-2, an end of a link 3-2, and an end of a link 4-2 respectively.

Optionally, more connection portions may be further disposed on the PCB, to assemble more FPCs (for example, the second FPC shown in FIG. 2-3). In FIG. 3-2, an example in which a single FPC is assembled on the PCB by using two connection structures is used. Optionally, a single FPC may be assembled on the PCB by using more or fewer connection structures.

This application further provides a circuit board. FIG. 3-3 is a schematic top view of the circuit board. The circuit board may be an FPC in a hybrid-link circuit board. The circuit board may be understood with reference to the FPC described above (for example, any FPC shown in FIG. 2-1 to FIG. 2-3, FIG. 3-1, and FIG. 3-2). For example, one or more transmission lines are arranged in the FPC, and the one or more transmission lines include a third transmission line. A difference from the FPC described above lies in that two ends of the third transmission line are configured to electrically connect to a first transmission line and a second transmission line respectively.

A manner for connecting a transmission line in the FPC to a transmission line in a PCB is not limited in this application. Optionally, at least one matching connection portion may be disposed on the FPC, and the matching connection portion is used for assembly of the FPC on a PCB. The matching connection portion may correspond to a connection portion. For example, a first matching connection portion may include a first matching connection structure and a second matching connection structure. Refer to FIG. 3-3. It is assumed that the first matching connection structure and the second matching connection structure are configured to connect to a first connection structure and a second connection structure on the PCB respectively. After the FPC is assembled on the PCB by using the first matching connection structure and the second matching connection structure, all or some transmission lines in the FPC are electrically connected to transmission lines in the PCB. For example, two ends of the third transmission line in the FPC are electrically connected to a first transmission line and a second transmission line in the PCB respectively. Optionally, the FPC may be assembled on the PCB by using more or fewer connection structures on the PCB.

The matching connection portion may include one or more pins. An end of the pin is electrically connected to a transmission line in the FPC. After the matching connection portion is connected to the corresponding connection portion, another end of the pin is electrically connected to a pin of the connection portion. In FIG. 3-3, a solid circle represents a pin, and a link i-3 represents a trace section that is of a link i and that is in the FPC. For example, a link 1-3 represents the third transmission line described above. Refer to FIG. 3-2. The first matching connection structure includes but is not limited to four pins, and the four pins are electrically connected to an end of the link 1-3, an end of a link 2-3, an end of a link 3-3, and an end of a link 4-3 respectively. The second matching connection structure includes but is not limited to four pins, and the four pins are electrically connected to another end of the link 1-3, another end of the link 2-3, another end of the link 3-3, and another end of the link 4-3 respectively.

A parameter of the pin of the matching connection portion may match a parameter of the pin of the corresponding connection portion. The parameter of the pin may include at least one of the following: a quantity of pins, a pin spacing, and a pin shape.

Implementations of the connection portion and the matching connection portion are not limited in this application. The following describes possible implementations of the first connection structure and the first matching connection structure by using examples.

In a first possible implementation, the first connection structure is a part of the PCB.

For example, the first connection structure may include at least one pad formed on the PCB, and the pad is a pin of the first connection structure. Refer to FIG. 4-1. In FIG. 4-1, a solid circle in a dashed box may represent the pad in the first connection structure, a hollow circle in the dashed box may represent a via in the PCB, and a dashed straight line may represent a line in a conductive layer in the PCB. The pad is connected to the line in the conductive layer in the PCB through the via.

The first matching connection structure may include at least one pad formed on the FPC, and the pad is a pin of the first matching connection structure. Refer to FIG. 4-1. In FIG. 4-1, a solid circle in a dashed box may represent the pad in the first matching connection structure, a hollow circle in the dashed box may represent a via in the FPC, and a dashed straight line may represent a line in a conductive layer in a core board. The pad is connected to a prefabricated line in a core board in the FPC through the via.

A parameter of the pad in the first connection structure may match a parameter of the pad in the first matching connection structure. For example, a spacing between pads in the first connection structure is the same as a spacing between pads in the first matching connection structure. The pad in the first connection structure is soldered to the pad in the first matching connection structure, so that a transmission line in the PCB can be electrically connected to a transmission line in the FPC.

For example, the first connection structure may include at least one via in the PCB, and the via is a pin of the first connection structure. Refer to FIG. 4-2. A hollow circle in a dashed box may represent the via in the first connection structure, and a dashed straight line may represent a line in a conductive layer in a core board. The via may be electrically connected to a prefabricated line in a core board in the PCB.

The first matching connection structure may include at least one signal pin of the FPC, the signal pin is a pin of the first matching connection structure, and an end of the signal pin is electrically connected to a transmission line in the FPC. A parameter of the via in the first connection structure may match a parameter of the signal pin of the first matching connection structure. For example, a spacing between vias in the first connection structure is the same as a spacing between signal pins of the first matching connection structure, and the signal pin of the first matching connection structure may be inserted into the via in the first connection structure. The signal pin of the first matching connection structure is inserted into the via in the first connection structure, so that a transmission line in the PCB can be electrically connected to the transmission line in the FPC.

Alternatively, the first matching connection structure may include at least one via in the FPC, and the via is a pin of the first matching connection structure. A parameter of the via in the first connection structure matches a parameter of the via in the first matching connection structure. For example, a spacing between vias in the first connection structure is the same as a spacing between vias in the first matching connection structure. The via in the first connection structure and the via in the first matching connection structure may be aligned and laminated to obtain a composite board, and one or more vias are processed in the composite board, to allow the via in the first connection structure to communicate with the via in the first matching connection structure.

For example, the first connection structure may be a printed plug made at an edge of the PCB, and a signal pin of the printed plug is a pin of the first connection structure. The first matching connection structure may be a socket or an insertion slot made in the FPC, or the first matching connection structure is a socket or an insertion slot assembled on the FPC. A pin of the first matching connection structure is a pin of the socket or the insertion slot. The printed plug is inserted into the socket or the insertion slot, so that a transmission line in the PCB is electrically connected to a transmission line in the FPC.

In a second possible implementation, the first connection structure is a component assembled on the PCB.

For example, with reference to FIG. 4-3, the first connection structure is a connector assembled on the PCB. Refer to FIG. 4-4. The first matching connection structure is a connector assembled on the FPC or a connector made on the FPC. The two connectors may be a male connector (for example, a plug) and a female connector (for example, a socket or an insertion slot). A pin of the first connection structure is a pin of the connector, and an end of the pin is electrically connected to a transmission line (for example, the first transmission line) in the PCB. A pin of the first matching connection structure is a pin of the connector, and an end of the pin is electrically connected to a transmission line (for example, the third transmission line) in the FPC. After the first connection structure is in insertion connection to the second connection structure, the pin of the first connection structure and the pin of the second connection structure are in contact with and electrically connected to each other, so that the transmission line in the PCB is electrically connected to the transmission line in the FPC. For example, a first end of the first transmission line is electrically connected to an end of the third transmission line.

It can be learned from the foregoing possible implementations of the first connection structure and the first matching connection structure that, when the connection structure on the PCB and/or the matching connection structure on the FPC are/is an additionally assembled component, in addition to a transmission line in the PCB and a transmission line in the FPC, a hybrid link in the circuit board may further include a transmission line in a corresponding component (for example, the pin of the connector shown in FIG. 4-3 or FIG. 4-4).

An implementation of the second connection structure may be the same as an implementation of the first connection structure. For example, the first connection structure includes a plurality of pads (referred to as first pads) on the PCB, and the second connection structure includes a plurality of pads (referred to as second pads) other than the first pads on the PCB. Alternatively, an implementation of the second connection structure may be different from an implementation of the first connection structure. For example, the first connection structure includes at least one pad or at least one via formed on the PCB, and the second connection structure is a connector assembled on the PCB.

In FIG. 3-2, an example in which the first connection structure and the second connection structure are rectangular is used. A shape of the connection structure on the PCB is not limited in this application. Similarly, in FIG. 3-3, an example in which the first matching connection structure and the second matching connection structure are rectangular is used. A shape of the matching connection structure on the FPC is not limited in this application.

In the circuit described above, a type of the transmission line in the circuit board is not limited in this application. For example, the transmission line may be a single-ended transmission line or a differential pair. The single-ended transmission line is a single conductive line (briefly referred to as a line) used for transmission of a single-ended signal. After a transmit end sends a single-ended signal to a receive end, the receive end determines, by comparing a difference between the single-ended signal and a reference signal, information sent by the transmit end. The differential pair is a pair of lines with coupling, and is used for transmission of a differential signal. The differential signal includes two signals with same amplitude and opposite phases. After the transmit end sends a differential signal to the receive end, the receive end determines, by comparing a difference between two signals in a differential pair, information sent by the transmit end. Compared with single-ended signal transmission, differential signal transmission has advantages such as a strong anti-interference capability and effective suppression of electromagnetic interference and therefore is increasingly widely applied in high-speed circuits.

FIG. 5 is a schematic partial top view of a circuit board. The circuit board may be a PCB or an FPC. The circuit board includes a differential pair and a plurality of vias, and an end of a line in the differential pair is electrically connected to a corresponding pin through the via. In FIG. 5, a hollow circle represents a via, and a solid circle represents a pin. For simplicity of the figure, FIG. 5 schematically shows one differential pair in the circuit board and corresponding pins. In FIG. 5, an example in which the pin is a pad is used. Optionally, the pin may be another type of pin, for example, may be understood with reference to the pin of the junction portion, the connection portion, or the matching connection portion described above.

A large quantity of components in high density are usually disposed on a circuit board in a high-density scenario. In addition, with wide application of differential signals in the high-density scenario, pin density of the circuit board is increased significantly. This causes a significant decrease in a spacing between different lines in a differential pair. An excessively small spacing causes a high crosstalk loss in a differential signal, and restricts wide application of differential signal transmission in a high-density high-speed scenario.

In consideration of both high pin density and a low crosstalk loss, this application further provides a circuit board. One or more transmission lines are arranged in the circuit board, the one or more transmission lines include a target transmission line, the target transmission line is a differential pair, and the differential pair is a differential pair with a variable spacing. In this application, two lines in the target transmission line are referred to as a first line and a second line. The first line includes a plurality of coupled trace sections, the coupled trace section is a trace section that is in the first line and that is coupled to the second line, and coupling spacings of at least two coupled trace sections are different. A coupling spacing of a coupled trace section is a spacing between the coupled trace section and the second line. More specifically, the coupling spacing of the coupled trace section is a spacing between the coupled trace section and a trace section that is in the second line and that is coupled to the coupled trace section. Optionally, the spacing between the coupled trace section and the trace section that is in the second line and that is coupled to the coupled trace section may be a spacing between projections of the coupled trace section and the trace section that is in the second line and that is coupled to the coupled trace section onto a same surface (for example, a first surface) of the circuit board. The following uses an example in which a coupling spacing is a spacing between projections for description.

An end part (for example, a first end or a second end) of the first line is configured to connect to a pin of the circuit board. In this application, a coupled trace section that is in the plurality of coupled trace sections and that is closest to the end part of the first line is referred to as an outlet trace section. A coupling spacing of the outlet trace section affects a spacing between a pin connected to the first line and a pin connected to the second line. A larger coupling spacing of the outlet trace section generally indicates a larger spacing between the pin connected to the first line and the pin connected to the second line. Conversely, a smaller coupling spacing of the outlet trace section generally indicates a smaller spacing between the pin connected to the first line and the pin connected to the second line.

In this way, a coupled trace section with a small coupling spacing is disposed at the end part of the first line or near the end part (for example, in a dashed box shown in FIG. 5). This helps increase pin density of the circuit board, to meet a requirement in a high-density scenario. In addition, a coupled trace section with a large coupling spacing is disposed at a middle part between two ends of the first line. This helps reduce a crosstalk loss of a differential signal in the target transmission line, to meet a requirement in a high-speed scenario.

A material of the circuit board is not limited in this application. For example, the circuit board may be a PCB, an FPC, or the like. The PCB may be the PCB in the hybrid-link circuit board described above or the PCB in the circuit described above. The FPC may be the FPC in the hybrid-link circuit board described above or the FPC in the circuit described above.

For example, the circuit board may be the PCB shown in FIG. 1-1 and FIG. 1-2, and the transmission line 0 in the PCB may be a target transmission line (namely, a differential pair with a variable spacing). Alternatively, the circuit board may be the PCB shown in FIG. 2-1 or FIG. 2-2, and at least one transmission line (for example, the first transmission line and/or the second transmission line) in the PCB may be a target transmission line. Alternatively, the circuit board may be the first FPC shown in FIG. 2-1 or FIG. 2-2, and at least one transmission line (for example, the third transmission line) in the first FPC may be a target transmission line.

The following describes a trace design of the target transmission line in the circuit board.

FIG. 6-1 is a possible partial top view of the circuit board. Refer to FIG. 6-1. The circuit board includes but is not limited to a first differential pair. The first differential pair is the target transmission line described above, and includes the first line and the second line. The first line may include but is not limited to a first coupled trace section and a second coupled trace section. A spacing of the first coupled trace section is different from a spacing of the second coupled trace section.

The first coupled trace section is parallel-coupled to the second line. For ease of description, a trace section that is in the second line and that is coupled to the first coupled trace section is referred to as a first trace section, and a spacing between a projection of the first coupled trace section onto the first surface and a projection of the first trace section onto the first surface is referred to as a first spacing. The second coupled trace section is parallel-coupled to the second line. For ease of description, a trace section that is in the second line and that is coupled to the second coupled trace section is referred to as a second trace section, and a spacing between a projection of the second coupled trace section onto the first surface and a projection of the second trace section onto the first surface is referred to as a second spacing. As shown in FIG. 6-1, the first spacing is less than the second spacing. In FIG. 6-1, an example in which the first spacing is 0 is used. Optionally, the first spacing may be greater than 0, provided that the first spacing is different from the second spacing.

FIG. 6-2 is a sectional view of the circuit board shown in FIG. 6-1 in a plane A. Refer to FIG. 6-2. The first coupled trace section and the first trace section are located at different thicknesses of the circuit board or in different conductive layers. In other words, the first coupled trace section and the first trace section are broadside-coupled to each other in the circuit board.

FIG. 6-3 is a sectional view of the circuit board shown in FIG. 6-1 in a plane B. Refer to FIG. 6-3. The second coupled trace section and the second trace section are located at different thicknesses of the circuit board or in different conductive layers. In other words, the second coupled trace section and the second trace section are broadside-coupled to each other in the circuit board.

Optionally, a coupling spacing of the first coupled trace section is 0, and the first coupled trace section may be disposed at an end of the first line, or the first coupled trace section is a coupled trace section that is in the plurality of coupled trace sections and that is closest to the pin connected to the first line. This helps improve pin density.

FIG. 6-4 is another possible schematic partial top view of the circuit board. Refer to FIG. 6-4. An end of the first line starts from a first coupled trace section, and is connected to a first via in the circuit board through a first access trace section. The first via may be a pin of the circuit board, or the first via is connected to a pin (not shown in FIG. 6-4) of the circuit board. Similarly, an end of the second line starts from a first trace section, and is connected to a second via in the circuit board through a second access trace section. The second via may be a pin of the circuit board, or the second via is connected to a pin (not shown in FIG. 6-4) of the circuit board.

Optionally, with reference to FIG. 6-4, for any position on the first coupled trace, a distance between the position and the first via is the same as a distance between the position and the second via. This helps avoid electric leakage caused by an excessively small distance between the first line and the first via or the second via.

Because the first coupled trace section and the first trace section are located at different thicknesses of the circuit board, lengths of the first via and the second via are different. For example, FIG. 6-5 is a sectional view of the circuit board shown in FIG. 6-4 in a plane C, and the length of the first via is less than the length of the second via. When lengths of vias that the first line and the second line pass through are different, lengths of the two lines are different, causing a delay difference between two signals in a differential signal and increasing attenuation of the differential signal. Still refer to FIG. 6-4. To reduce the delay difference, a length of the first access trace section may be greater than a length of the second access trace section, to compensate for a difference between the lengths of the first via and the second via.

FIG. 6-1 schematically shows two coupled trace sections in the first line. Optionally, the first line includes more coupled trace sections (for example, a third coupled trace section described below). In FIG. 6-1, an example in which the first coupled trace section and the second coupled trace section are two adjacent coupled trace sections is used. Optionally, another coupled trace section (for example, the third coupled trace section described below) may be further included between the first coupled trace section and the second coupled trace section.

FIG. 7-1 is another possible partial top view of the circuit board. Refer to FIG. 7-1. The circuit board includes but is not limited to a second differential pair. The second differential pair is the target transmission line described above, and the second differential pair includes the first line and the second line. The first line may include but is not limited to a first coupled trace section and a third coupled trace section. A spacing of the first coupled trace section is different from a spacing of the third coupled trace section.

For understanding of the first coupled trace section, refer to the first coupled trace section shown in FIG. 6-1. For understanding of the sectional view of the circuit board in a plane D shown in FIG. 7-1, refer to FIG. 6-2. For example, the first coupled trace section is broadside-coupled to a first trace section in the second line, and a spacing between projections of the first coupled trace section and the first trace section onto the first surface is a first spacing.

The third coupled trace section is parallel-coupled to the second line. For ease of description, a trace section that is in the second line and that is coupled to the third coupled trace section is referred to as a third trace section, and a spacing between a projection of the third coupled trace section onto the first surface and a projection of the third trace section onto the first surface is referred to as a third spacing. As shown in FIG. 7-1, the first spacing is less than the third spacing. In FIG. 7-1, an example in which the first spacing is 0 is used. Optionally, the first spacing may be greater than 0, provided that the first spacing is different from the third spacing.

FIG. 7-2 is a sectional view of the circuit board shown in FIG. 7-1 in a plane E. Refer to FIG. 7-2. The third coupled trace section and the third trace section are located at a same thickness of the circuit board or in a same conductive layer. In other words, the third coupled trace section and the third trace section are edge-coupled to each other in the circuit board.

In FIG. 7-1, a black circle represents a via in the circuit board. The second line may reach, through the via from a conductive layer in which the first trace section is located, a conductive layer in which the third trace section is located. In other words, a trace section that is in the first line and that is located between the first trace section and the third trace section includes a via, to change a coupling type of the first line and the second line.

In FIG. 7-1, an example in which the first trace section and the third trace section are located in different conductive layers is used. Optionally, the first trace section and the third trace section may be located in a same conductive layer, and the first coupled trace section and the third coupled trace section are located in different conductive layers. Correspondingly, a trace section that is in the first line and that is located between the first coupled trace section and the third coupled trace section includes a via, to change a coupling type of the first line and the second line.

The spacing between the projection of the first coupled trace section onto the first surface and the projection of the first trace section onto the first surface is the first spacing, and the spacing between the projection of the third coupled trace section onto the first surface and the projection of the third trace section onto the first surface is the third spacing. As shown in FIG. 7-1, the first spacing is less than the third spacing. In FIG. 7-1, an example in which the first spacing is 0 is used. Optionally, the first spacing may be greater than 0, provided that the first spacing is different from the third spacing.

FIG. 7-1 schematically shows two coupled trace sections in the first line. Optionally, the first line includes more coupled trace sections. For example, in addition to the first coupled trace section and the third coupled trace section, the first line may further include the second coupled trace section described above.

In FIG. 7-1, an example in which the first coupled trace section and the third coupled trace section are two adjacent coupled trace sections is used. Optionally, another coupled trace section may be further included between the first coupled trace section and the third coupled trace section. For example, the second coupled trace section may be further included between the first coupled trace section and the third coupled trace section.

The foregoing describes possible structures of the circuit board by using examples with reference to FIG. 6-1 to FIG. 6-5, FIG. 7-1, and FIG. 7-2. In some examples, the circuit board may include more differential pairs. For example, the circuit board may include a first differential pair and a second differential pair.

In this application, a coupled trace section that is in the plurality of coupled trace sections in the first line and that is adjacent to the first coupled trace section is referred to as a fourth coupled trace section, and a trace section that is in the second line and that is parallel-coupled to the fourth coupled trace section is referred to as a fourth trace section. In addition, in this application, a trace section that is in the first line and that is located between the first coupled trace section and the fourth coupled trace section is referred to as a first intermediate trace section, and a trace section that is in the second line and that is located between the first trace section and the fourth trace section is referred to as a second intermediate trace section.

In FIG. 6-1 and FIG. 7-1, an example in which projections of the first intermediate trace section and the second intermediate trace section onto a same surface of the circuit board do not intersect is used. Optionally, there is at least one position of intersection between the projections of the first intermediate trace section and the second intermediate trace section onto the same surface of the circuit board. Cross-interchanging transmission positions of a positive signal and a negative signal in a differential signal helps reduce crosstalk between the positive signal and the negative signal, to meet a requirement in a high-speed scenario. A quantity of positions of intersection is not limited in this application.

In some examples, a coupling spacing of the fourth coupled trace section may be different from a coupling spacing of the first coupled trace section. For example, the fourth coupled trace section may be the second coupled trace section or the third coupled trace section. An example in which the fourth coupled trace section is the third coupled trace section is used. FIG. 8-1 is another possible schematic partial top view of the circuit board. Refer to FIG. 8-1. There is one position of intersection between the projections of the first intermediate trace section and the second intermediate trace section onto the same surface of the circuit board.

Alternatively, in some examples, the coupling spacing of the fourth coupled trace section may be the same as the coupling spacing of the first coupled trace section. FIG. 8-2 is another possible schematic partial top view of the circuit board. Refer to FIG. 8-2. There are two positions of intersection between the projections of the first intermediate trace section and the second intermediate trace section onto the same surface of the circuit board.

Two trace sections that are broadside-coupled to each other in the circuit board are located at different thicknesses of the circuit board. For example, with reference to FIG. 6-2, the first coupled trace section and the first trace section are located at different thicknesses of the circuit board. The circuit board is generally formed by laminating a plurality of core boards based on prefabricated lines and interlayer alignment. The core board includes a conductive layer and an insulating layer, and two trace sections that are broadside-coupled to each other may be prefabricated in different conductive layers.

FIG. 9-1 schematically shows a processing process of a circuit board. In FIG. 9-1, a black rectangle represents a prefabricated line in a conductive layer in a core board, and a white rectangle represents an insulating layer in the core board. Refer to FIG. 9-1. A first coupled trace section is prefabricated in a conductive layer in a core board 1, and a first trace section is prefabricated in a conductive layer in a core board 2. A circuit board shown in FIG. 9-2 is obtained by adjusting relative positions of the two core boards in a direction parallel to a surface of the core board and laminating the two core boards by using a first bonding sheet, so that the first coupled trace section is parallel to the first trace section, and a spacing between projections of the first coupled trace section and the first trace section onto a surface of the circuit board is a specified spacing (for example, 0). A layer deviation of the first coupled trace section and the first trace section is large due to low precision of an alignment and lamination process. For example, the first coupled trace section and the first trace section are not parallel, or a spacing between the first coupled trace section and the first trace section greatly differs from a specified spacing. The large layer deviation increases impedance fluctuation and crosstalk fluctuation of a differential pair, and reduces signal integrity (signal integrity, SI) of the differential pair.

To reduce the layer deviation, this application provides a circuit board. The circuit board may be a PCB or an FPC. The circuit board includes a plurality of core boards, a bonding sheet is disposed between adjacent core boards in the plurality of core boards, and a first coupled trace section and a trace section that is in a second line and that is coupled to the first coupled trace section are prefabricated on different surfaces of a first core board in the plurality of core boards.

FIG. 10-1 schematically shows another processing process of a circuit board. In FIG. 10-1, a black rectangle represents a prefabricated line in a conductive layer in a core board, and a white rectangle represents an insulating layer in the core board. Refer to FIG. 10-1. A first coupled trace section is prefabricated in a conductive layer in a first core board, and a first trace section is prefabricated in another conductive layer in the first core board. A circuit board shown in FIG. 10-2 may be obtained by laminating a second core board to a surface of the first core board by using a first bonding sheet and laminating a third core board to another surface of the first core board by using a second bonding sheet. Because precision of a process for prefabricating a line on a core board is far higher than the precision of the alignment and lamination process, this helps reduce a layer deviation of the first coupled trace section and the first trace section, to reduce impedance fluctuation and crosstalk fluctuation of a differential pair and improve signal integrity (signal integrity, SI) of the differential pair.

This application further provides an electronic device. The electronic device includes but is not limited to a plurality of circuits. The circuit may include a circuit board and a plurality of components assembled on the circuit board. At least one of the plurality of circuits may be the circuit based on the hybrid-link circuit board described above, for example, the circuit shown in FIG. 2-1 and FIG. 2-2 or the circuit shown in FIG. 2-3.

In some examples, the electronic device may further include a housing, and the circuit of the electronic device is disposed in the housing. A structure of the housing is not limited in this application. For example, one or more slot positions are disposed on the housing, and the slot position is used for one or more circuits to be inserted into.

Functions and a quantity of components in the electronic device are not limited in this application, and a manufacturer may perform corresponding configuration based on a type or a function of the electronic device. The type or the function of the electronic device is not limited in this application. For example, the electronic device may be a computer device.

The following describes possible components in the electronic device by using an example in which the electronic device is a computer device.

The computer device may include a processor. The processor may include one or more general-purpose processors, for example, a central processing unit (central processing unit, CPU), or a combination of a CPU and a hardware chip. The hardware chip may be an application-specific integrated circuit (application-specific integrated circuit, ASIC), a programmable logic device (programmable logic device, PLD), or a combination thereof. The PLD may be a complex programmable logic device (complex programmable logic device, CPLD), a field-programmable gate array (field-programmable gate array, FPGA), generic array logic (generic array logic, GAL), or any combination thereof.

The computer device may include a memory. The memory may include a volatile memory (volatile memory), for example, a random access memory (random access memory, RAM). The memory 902 may alternatively include a non-volatile memory (non-volatile memory), for example, a read-only memory (read-only memory, ROM), a flash memory (flash memory), a hard disk drive (hard disk drive, HDD), or a solid-state drive (solid-state drive, SSD). The memory may alternatively include a combination of the foregoing types.

The computer device may include a communication interface. The communication interface may be a wired interface or a wireless interface.

The foregoing descriptions are merely examples. The electronic device may include more or fewer types of components.

An application field of the computer device is not limited in this application. For example, the computer device may be used in any one of the field of data communication, the field of data transmission, the field of computing, and the field of communication. For example, the computer device may be a chassis core router or a switch.

The following describes a possible structure of the electronic device by using an example in which the computer device is a switch.

FIG. 11 schematically shows a possible structure of an electronic device. Refer to FIG. 11. The electronic device may include a circuit 1 and a circuit 2. The circuit 1 may be a switch fabric unit, and the circuit 2 may be a service line card. The circuit 1 includes a circuit board 1, and a chip 1 and a connector 1 that are assembled on the circuit board 1. The chip 1 is a primary chip in the switch fabric unit. The circuit 2 includes a circuit board 2, and a chip 2 and a connector 2 that are assembled on the circuit board 2. The chip 2 may be a service chip. FIG. 11 is merely used as an example. A quantity of circuits of the electronic device, and a quantity and types of components assembled on a circuit are not limited in this application.

In the plurality of circuits of the electronic device, at least one circuit may be the circuit based on the hybrid-link circuit board described above. For example, with reference to FIG. 11, the circuit board 1 includes a PCB 1 and an FPC 1 assembled on the PCB 1, and the chip 1 is electrically connected to the connector 1 through a first link. A track of the first link starts from the chip 1, and sequentially passes through the PCB 1, the FPC 1, and the PCB 1 until reaching a pin of the connector 1. For understanding of the PCB 1, the FPC 1, the chip 1, the connector 1, and the first link, refer to the PCB, the first FPC, the first component, the second component, and the link 1 shown in FIG. 2-1.

Similarly, with reference to FIG. 11, the circuit board 2 includes a PCB 2 and an FPC 2 assembled on the PCB 2, and the chip 2 is electrically connected to the connector 2 through a second link. A track of the second link starts from the chip 2, and sequentially passes through the PCB 2, the FPC 2, and the PCB 2 until reaching a pin of the connector 2. For understanding of the PCB 2, the FPC 2, the chip 2, the connector 2, and the second link, refer to the PCB, the first FPC, the first component, the second component, and the link 1 shown in FIG. 2-1.

In FIG. 11, an example in which both the circuit board 1 and the circuit board 2 are hybrid-link circuit boards described above is used. Optionally, the circuit board 2 may not include an FPC. For example, a track of the second link starts from the chip 2, and reaches the connector 2 through the PCB 2.

In the electronic device, at least two of the plurality of circuits may be interconnected. A manner of interconnection between different circuits is not limited in this application. Refer to FIG. 11. The circuit 1 and the circuit 2 may be interconnected by using the connector 1 on the circuit board 1 and the connector 2 on the circuit board 2.

Refer to FIG. 11. After the circuit 1 and the circuit 2 are interconnected, a signal may be transmitted between the chip 1 and the chip 2. For example, a signal sent by the chip 1 may sequentially pass through the first link, the pin of the connector 1, the pin of the connector 2, and the second link until reaching the chip 2. The first link and the second link may be hybrid links. Based on the hybrid-link circuit board described above, a core board with a dielectric loss less than that of the PCB 1 and the PCB 2 may be selected for the FPC 1 and the FPC 2, and a high-speed signal is transmitted in a hybrid link. This helps reduce a transmission loss of the high-speed signal in the link 1 and the link 2, to meet a requirement in a high-speed scenario. In addition, because a quantity of core boards in the FPC is generally far less than a quantity of core boards in the PCB, compared with selecting an expensive core board with a low dielectric loss for the PCB, selecting a core board with a low dielectric loss for the FPC 1 and the FPC 2 helps reduce costs of the circuit board, and further improves cost competitiveness of the electronic device in a high-speed high-density scenario.

In the foregoing examples, descriptions of the examples have respective focuses. For a part that is not described in detail in an example, refer to related descriptions in other examples. It should be further appreciated by a person skilled in the art that examples described in the specification all belong to preferred examples, and the related actions and modules are not necessarily required by this application. "A and/or B" in examples of this application may be understood as including two solutions: "A and B" and "A or B". In the specification, claims, and accompanying drawings of this application, the terms "first", "second", "third", "fourth", and the like are intended to distinguish between similar objects but do not necessarily indicate a specific order or sequence. It should be understood that terms used in such a way are interchangeable in proper circumstances, which is merely a discrimination manner that is used when objects having a same attribute are described in examples of this application. In the several examples provided in this application, it should be understood that the disclosed apparatus may be implemented in another manner. For example, the described apparatus example is merely an example. For example, division into the units is merely logical function division and may be other division during actual implementation. The foregoing examples are merely used to describe the technical solutions of this application, but are not intended to limit this application.

## Claims

1. A circuit board, comprising a printed circuit board PCB and one or more flexible printed circuits FPCs assembled on the PCB, wherein the one or more FPCs comprise a first FPC;
one or more transmission lines are arranged in the first FPC; and
one or more transmission line groups are arranged in the PCB, a first transmission line group in the one or more transmission line groups comprises a first transmission line and a second transmission line, a first end of the first transmission line and a first end of the second transmission line are electrically connected to two ends of a third transmission line in the one or more transmission lines, and a second end of the first transmission line and a second end of the second transmission line are configured to electrically connect to different components.

2. The circuit board according to claim 1, wherein a target transmission line is arranged in a target circuit board, the target circuit board is the PCB or one of the one or more FPCs, the target transmission line is a differential pair, the target transmission line comprises a first line and a second line, the first line comprises a plurality of coupled trace sections, the plurality of coupled trace sections are coupled to the second line, and spacings between at least two of the plurality of coupled trace sections and the second line are different.

3. The circuit board according to claim 2, wherein a first coupled trace section in the at least two coupled trace sections and the second line are broadside-coupled to each other in the target circuit board.

4. The circuit board according to claim 2 or 3, wherein the at least two coupled trace sections comprise a second coupled trace section, and the second coupled trace section and the second line are broadside-coupled to each other in the target circuit board.

5. The circuit board according to any one of claims 2 to 4, wherein the at least two coupled trace sections comprise a third coupled trace section, and the third coupled trace section and the second line are edge-coupled to each other in the target circuit board.

6. The circuit board according to any one of claims 3 to 5, wherein a spacing between the first coupled trace section and the second line is a spacing between projections of the first coupled trace section and a trace section that is in the second line and that is coupled to the first coupled trace section onto a surface of the target circuit board.

7. The circuit board according to any one of claims 3 to 6, wherein the plurality of coupled trace sections comprise a fourth coupled trace section adjacent to the first coupled trace section, the first line further comprises a first intermediate trace section located between the first coupled trace section and the fourth coupled trace section, and there is at least one position of intersection between projections of the first intermediate trace section and the second line onto the surface of the target circuit board.

8. The circuit board according to any one of claims 3 to 7, wherein the target circuit board comprises a plurality of core boards, a bonding layer is disposed between two adjacent core boards in the plurality of core boards, and the first coupled trace section and the trace section that is in the second line and that is coupled to the first coupled trace section are prefabricated on different surfaces of a first core board in the plurality of core boards.

9. The circuit board according to claim 8, wherein the first core board comprises an insulating layer, and a material of the insulating layer comprises an organic flexible material or an inorganic flexible material; the organic flexible material comprises at least one of the following: polyimide PI, polytetrafluoroethylene PTFE, liquid crystal polymer LCP, modified polyimide MPI, polyester film, perfluoropropyl perfluorovinyl ether, and polyfluoroalkoxy FPA; and the inorganic flexible material comprises carbon fiber or glass fiber cloth.

10. A circuit board, comprising a printed circuit board PCB and one or more connection portions on the PCB, wherein
the one or more connection portions are used for assembly of one or more flexible printed circuits FPCs, a first connection portion in the one or more connection portions is used for assembly of a first FPC in the one or more FPCs, and one or more transmission lines are arranged in the first FPC; and
one or more transmission line groups are arranged in the PCB, a first transmission line group in the one or more transmission line groups comprises a first transmission line and a second transmission line, and when the first FPC is assembled on the first connection portion, a first end of the first transmission line and a first end of the second transmission line are electrically connected to two ends of a third transmission line in the one or more transmission lines respectively, and a second end of the first transmission line and a second end of the second transmission line are configured to electrically connect to different components.

11. The circuit board according to claim 10, wherein the first connection portion comprises a first connection structure, the first connection structure comprises at least one pad or at least one via formed on the PCB, and the first end of the first transmission line is electrically connected to one pad in the at least one pad or one via in the at least one via.

12. The circuit board according to claim 10 or 11, wherein the first connection portion comprises a second connection structure, the second connection structure comprises a connector assembled on the PCB, and the first end of the second transmission line is electrically connected to a pin of the connector.

13. A circuit board, wherein one or more transmission lines are arranged in the circuit board; and
the one or more transmission lines comprise a target transmission line, the target transmission line is a differential pair, the target transmission line comprises a first line and a second line, the first line comprises a plurality of coupled trace sections, the plurality of coupled trace sections are coupled to the second line, and spacings between at least two of the plurality of coupled trace sections and the second line are different.

14. The circuit board according to claim 13, wherein a first coupled trace section in the at least two coupled trace sections and the second line are broadside-coupled to each other in the circuit board.

15. The circuit board according to claim 13 or 14, wherein the at least two coupled trace sections comprise a second coupled trace section, and the second coupled trace section and the second line are broadside-coupled to each other in the circuit board.

16. The circuit board according to any one of claims 13 to 15, wherein the at least two coupled trace sections comprise a third coupled trace section, and the third coupled trace section and the second line are edge-coupled to each other in the circuit board.

17. The circuit board according to any one of claims 14 to 16, wherein a spacing between the first coupled trace section and the second line is a spacing between projections of the first coupled trace section and a trace section that is in the second line and that is coupled to the first coupled trace section onto a surface of the circuit board.

18. The circuit board according to any one of claims 14 to 17, wherein the plurality of coupled trace sections comprise a fourth coupled trace section adjacent to the first coupled trace section, the first line further comprises a first intermediate trace section located between the first coupled trace section and the fourth coupled trace section, and there is at least one position of intersection between projections of the first intermediate trace section and the second line onto the surface of the circuit board.

19. The circuit board according to any one of claims 14 to 18, wherein the circuit board comprises a plurality of core boards, a bonding layer is disposed between two adjacent core boards in the plurality of core boards, and the first coupled trace section and the trace section that is in the second line and that is coupled to the first coupled trace section are prefabricated on different surfaces of a first core board in the plurality of core boards.

20. The circuit board according to any one of claims 13 to 19, wherein the circuit board is a printed circuit board PCB or a flexible printed circuit FPC.

21. An electronic device, comprising one or more circuit boards and a plurality of components assembled on the one or more circuit boards, wherein at least one of the one or more circuit boards is the circuit board according to any one of claims 1 to 20.

22. The electronic device according to claim 21, wherein the electronic device further comprises a housing, and the one or more circuit boards are disposed in the housing.
